# EUROPEAN PATENT APPLICATION

(11) **EP 4 311 384 A1**
(43) Date of publication of application: **24.01.2024**
(21) Application number: 22186504.1
(22) Date of filing: 22.07.2022
(51) Int. Cl.: H05K 7/20

(54) **COOLING SYSTEM WITH FLOW GUIDING ELEMENT**

(71) Applicant: Aptiv Technologies Limited, St. Michael (BB)
(72) Inventor: KORTA, Jakub, 31-241 Kraków (PL); STANEK, Lukasz, 30-102 Kraków (PL)
(74) Representative: Bardehle Pagenberg Partnerschaft mbB Patentanwälte Rechtsanwälte

(57) **Abstract**

The present invention relates to a cooling system for an electrical control unit of a vehicle, the cooling system (1) comprising: a cooling element (10) comprising a first (11) and second (12) flow channel for a coolant; a flow reverse element (20; 20'; 20") adapted to guide coolant from the first flow channel (11) to the second flow channel (12); a flow guiding element (30; 30') for guiding at least part of the coolant from the first flow channel (11) to the second flow channel.

## Description

### Technical field

The present invention relates to a cooling system for an electrical control unit, such as a processing unit, of a vehicle. The invention further relates to a vehicle comprising such a cooling system.

### Technical background

Advanced driver assistance systems (ADAS) as well as automated driving (AD) capabilities are facing an increasing popularity and enjoy a wide range of applications in the automotive sector. With an increasing number of e.g. electric or hybrid vehicles, a demand for such systems and capabilities is expected to rise as they become even more important in the nearer future. Additionally, there is a rising interest for infotainment or communication controllers among users.

Such ADAS, AD capabilities, infotainments and/or communication controllers and capabilities require large amount of computational power, which may usually be provided by electronic devices, such as on-board high-end electronic devices. Examples of such devices also include domain and multi-domain controllers equipped with processing units or systems-on-a-chip. As an example, the devices may also be part of a vehicle processing unit.

Such electronic devices produce, during operation, a large amount of heat. This heat can shorten the expected lifetime of said devices and hence adversely affect the operation thereof. These detrimental effects are even exacerbated when the devices are exposed to harsh environmental conditions, such as ambient temperatures above 50°C or even above 85°C. In some cases, such high temperatures may even cause failure of these devices.

In order to maintain the operating temperature of the electronic devices within acceptable limits and to facilitate a reliable operation thereof, cooling of these device is becoming more important. In particular, this calls for the provision of a reliable heat management.

Conventional means to provide for liquid cooling of automotive electronic devices may use a cold plate, to which a controller's housing is attached. Such an attachment could be performed via a layer of thermal interface material. The cold plate could be placed between two or more electronic devices, in order to take up heat from the devices during operation. Such cold plates are usually manufactured in a simplified and cost-effective manner to make mass production accessible. Accordingly, they are often manufactured with simple longitudinal profiles, which necessitates the provision of a closing cap to close the flow conduits of the cold plate and to turn the flow.

The disadvantage of these closing caps is that they lead to flow disturbances of the liquid cooling medium, causing a development of flow vortexes which culminates in an increased pressure loss. It may also be possible that the flow separates from surfaces, which further detrimentally contributes to an increased pressure loss. These flow phenomena adversely affect the cooling effectiveness. In particular, regions comprising vortexes reduce the heat exchange rate in such regions.

In view of the above disadvantages, the closing caps could be designed to turn the flow smoothly, by increasing the size of the corners.

However, such an approach is far from optimal. For example, more space is required for these closing caps, which is disadvantageous for many applications. For example, in tight automotive assemblies, additional space for such cooling systems is not available.

Against this background, there is a need in the art for an improved cooling system for cooling down electrical devices, e.g. a cooling system for an electrical control unit of a vehicle, such as a processing unit, electrical inverter, batteries, any electronic equipment or the like.

Hence, an object of the present invention is to improve the deficiencies of the prior art and to address one or more of the above-mentioned shortcomings of the prior art. It is particularly an object to provide a cooling system, such as for electronic parts of the automotive sector that provides for a reduced pressure loss and an increased cooling effectiveness compared to existing solution. It is further an object to provide a cooling system that complies with space restrictions that come with many applications such as in the automotive sector. It is generally an object to provide a cooling system with increased flexibility, functionality and reliability.

These and other objects, which become apparent from the following description, are solved by the subject-matter of the independent claims.

### Summary of the invention

An aspect of the invention relates to a cooling system for an electrical control unit of a vehicle, the cooling system comprising: a cooling element comprising a first and second flow channel for a coolant; a flow reverse element adapted to guide coolant from the first flow channel to the second flow channel; a flow guiding element for guiding at least part of the coolant from the first flow channel to the second flow channel.

The first flow channel may be understood as an inflow channel, the second flow channel maybe understood as an outflow channel. As an example, the direction of flow of the second flow channel may be substantially in an opposite direction compared to the inflow channel.

In one example, the cooling system for an electrical control unit of a vehicle may be applied to cool parts, such as electrical parts of a vehicle. The electrical control unit may comprise a processing unit, an electrical inverter, a battery, any electronic and/or electrical equipment or the like or any combinations thereof. In a further example, it may cool down substantially small parts, such as electrical and/or electronic devices in the automotive sector. For instance, the first and/or second flow channel maybe regarded as microchannels. It may not necessarily be applied for large or heavy industrial applications.

This aspect may have the advantage that at least part of the coolant is guided from the first to the second flow channel in an improved manner. In particular, a pressure loss is mitigated compared to conventional cooling systems, as the flow can be guided without a development and/or occurrence of disturbances, vortices and/or flow separation. This promotes an increased cooling efficiency, as substantially no regions of flow separation occur within the cooling system, the flow reverse element and/or the second flow channel, in particular the second flow channel.

In one example, it is appreciated that flow guidance is particularly improved due to a reduction (and/or even elimination) of vortices, which enhances heat exchange. Flow guidance may be further improved, if the flow guiding element has a size (such as a cross-section) of about (e.g. slightly smaller than) the cross-section of the second flow channel. Further, as a pressure loss is substantially reduced, operation of the cooling system may be more economic and cost-effective.

Another advantage attributable to this aspect may be that the overall size of the flow reverse element can be kept relatively small (as further detailed below), whilst achieving the afore-mentioned advantage. Thereby, a geometric expansion of the cooling element could be relatively large compared to the overall size of the cooling system, which facilitates to provide a large effective cooling surface for cooling down parts.

The coolant may be any fluid that is suitable for cooling. As an example, the fluid could have a lower temperature compared to parts to be cooled. Preferably the coolant is a liquid coolant. The coolant may also be termed a refrigerant. The coolant may not necessarily be part of the first aspect and may thus not limiting to its scope. However, as understood by the skilled person, the cooling system should be suitable to guide said coolant through it.

The first and/or second flow channel may have a cross-section to effectively guide a coolant. As an example, the cross-section may be constant along a length of the first and/or second flow channel. In other words, the cross-section may be uniform along a direction of flow. Suitable examples of cross sections may be rectangular, circular, pentagonal, hexagonal cross-sections or combinations thereof. The cooling element could be provided by way of extrusion. As an example, it may be produced in a cost-effective and fast manner.

Preferably, the flow guiding element at least partially projects in the second flow channel.

This further improves guidance of the flow, e.g. the coolant (in particular from the first flow channel to the second flow channel). Thereby, a heat exchange is improved as less vortices evolve. Moreover, pressure loss may be further reduced. Such an arrangement of the flow guiding element at least partially projecting in the second flow channel promotes an increased cooling efficiency. If less or substantially no regions of flow separation occur within the cooling system, the cooling efficiency increases.

In a preferred embodiment, in the cooling system according to the preceding aspect, the flow guiding element projects from the flow reverse element into the second flow channel.

This embodiment may be understood in that the flow guiding element projects and/or extends from the flow reverse element into the second flow channel. Thus, it may be in contact with the flow reverse element.

This has the advantage that a flow of a coolant within the flow reverse element may already be in contact and/or in communication with the flow guiding element within the flow reverse element. Thereby, guidance of the flow can be significantly improved, as the flow may be guided in a targeted and/or envisaged direction. This facilitates to achieve a smooth flow from the flow reverse element into the second flow channel. Thus, the flow guiding element improves turning the flow to prevent flow separation.

In another preferred embodiment, the flow guiding element is part of the flow reverse element, preferably integral with the flow reverse element.

The flow guiding element and the flow reverse element may form a single piece. In particular, it is appreciated that they could be manufactured as a single piece. This has the advantage that a reduced number of (separate) parts have to be dealt with during assembling of the cooling system. Another advantage is that the positioning of the flow guiding element relative to the flow reverse element can already be determined at manufacturing of said single (integral) piece.

In one example, it may also be possible that the flow guiding element is provided as a separate piece compared to the flow reverse element. This may have the advantage that the flow guiding element could be manufactured separately, which may be advantageous to design the flow guiding element in an improved manner. If the flow guiding element is a separate piece, the flow guiding element could be connected to the flow reverse element.

It is appreciated that the flow guiding element is integral with the flow reverse element and, at the same time has dimensions that facilitate a projecting into the second flow channel. Said projecting may also be understood as an insertion and/or extension.

Preferably, the flow guiding element comprises a substantially rounded surface at a portion where the flow guiding element merges with the flow reverse element.

A rounded surface may be understood as having a curved shape, such as a curved shape in two, preferably three-spatial dimensions. Thus, the flow may be smoothly guided and less abrupt changes in a direction of flow may occur. This culminates in an improved flow as the pressure losses are reduced. In particular, the pressure losses are reduced by the flow when being turned in the flow reverse element and guided into the second flow channel by way of the rounded surface of the flow guiding element.

The arrangement at said merging portion is particularly advantageous as such portions may conventionally be subject to sharp edges and/or corners.

As an example, the rounded surface may at least partially face a direction of flow in the flow reverse element. Such a direction may be parallel to a longitudinal direction of the flow reverse element. This orientation may further facilitate an improved flow guidance.

In another preferred embodiment, the flow guiding element is shaped as a blade, having a thicker portion on a side facing a direction of flow of the coolant in the flow reverse element and a thinner portion on an opposite side.

As an example, the flow guiding element may be shaped as a wedge, fin and/or wing. It is appreciated that the flow guiding element comprises a discernable thicker portion to effectively guide a flow.

Further, the thinner portion has the advantage that, if a flow surrounds the flow guiding element it may remain mostly attached. Thus, in a wake of the flow guiding element, smooth streamlines of flow may be provided, without substantially causing pressure losses.

In a preferred embodiment, the flow reverse element has two opposing inner sides defining a flow path in between, wherein the flow guiding element extends into said flow path to at least 10%, preferably at least 20%, more preferably at least 30%, even more preferably at least 40%, most preferably at least 50% of a width of the flow path; and/or to at most 90%, preferably at most 80%, more preferably at most 70%, even more preferably at most 60%, most preferably at most 50% of a width of the flow path.

The flow guiding element should extend into the flow path to facilitate guidance of flow into the second flow channel. The flow guiding element should not extend too much into the flow path, otherwise, the flow path may be blocked and potential subsequent flow channels (e.g., further outflow channels) may be provided with a too small amount of coolant.

Thus, the inventors found that an optimal balance should be struck, which is about 50% of a width of the flow path.

In another preferred embodiment, the flow reverse element has an elongate shape, wherein the largest dimension is substantially perpendicular to the direction of the flow channels and the width dimension is in the direction of the coolant in the flow channels, wherein the largest dimension is at least 2 times larger than the width, preferably at least 4 times larger, more preferably at least 6 times larger, even more preferably at least 8 times larger and further more preferably at least 10 times larger.

This has the advantage that the flow reverse element has a compact size, e.g., the width is relatively small compared to the length (largest dimension). Thus, an increased effective cooling surface may be provided, as the cooling element can be increased relatively to the flow reverse element.

Preferably, one or more of the flow channels has/have a cross-section of at most 10 cm², preferably at most 5 cm², more preferably at most 2 cm², even more preferably at most 1 cm².

The flow channels have a relatively small cross-section. A cross-section may be understood as an effective area through which a fluid, such as a coolant, flows. In one example, it may comprise a boundary layer. It may also be possible to provide for smaller cross sections (e.g., at most 0.5 cm² or at most 0.2 cm²). As an example, the cross-section of one flow channel may comprise one or more sub-cross-sections in one plane.

In another preferred embodiment, the flow guiding element projects into the second flow channel by at least 10%, preferably at least 20%, more preferably at least 30%, even more preferably at least 40%, further more preferably at least 50%, most preferably at least 60% of a length of the flow guiding element.

A large projection into the second flow channel further facilitates guidance of the flow. This prevents regions of flow separation to evolve in the second flow channel.

As an example, the flow guiding element could be said to be elongated in the direction of the second flow channel (which may be parallel to the direction of the first flow channel).

Preferably, the cooling element may comprise additional flow channels, such as a third, fourth and optionally further flow channels. As an example, the flow reverse element may be adapted to guide coolant from the third to the fourth and optionally from one of the further flow channels to another of the further flow channels. Optionally, the cooling system comprises a plurality of flow guiding elements, preferably each of the flow guiding elements at least partially projecting into a flow channel into which coolant is guided by the flow reverse element.

It is noted that the same feature and advantages as described herein with regard to the flow guiding element also apply to any one of the plurality of flow guiding elements.

In a further preferred embodiment, at least two flow guiding elements are arranged in an alternating manner on the opposing inner sides of the flow reverse element.

Such an alternating manner has the advantage that the coolant may be properly guided through the flow path of the flow reverse element.

In a preferred embodiment, the cooling element is a substantially flat plate adapted for being connected to parts to be cooled; optionally wherein the flow reverse element comprises one or more, preferably two fastening means so as to act as a mounting bracket to external parts.

A flat plate may be understood as a plate which has two dimensions that are substantially larger than a third dimension. The flat plate may have a length and a height and a width (third dimension). The length and the height dimension may form a first surface that could be said to be in thermal contact with one or more parts to be cooled. A second surface may be formed on an opposite side compared to the first surface. Said second surface maybe in thermal contact with one or more (other) parts to be cooled.

The fastening means could be screws or the like. The flow reverse element facilitates multiple functions as it could provide for a bracket function to be conveniently connected to external parts. Said further parts do not necessarily need to be cooled. The fastening means may comprise integration fixation points, which facilitates reliable connections.

In another preferred embodiment, the cooling element is made of aluminum, preferably manufactured by extrusion, more preferably by direct extrusion; optionally wherein the flow reverse element is made of aluminum, preferably manufactured by impact extrusion, die casting or plastic injection.

Aluminum and/or aluminum alloy, has the advantage of a low price, adequate mechanical tolerances and excellent material thermal properties. As an example, a thermal conductivity of aluminum may reach 200W/m-K (Watts per meter and per Kelvin). Manufacturing of the cooling element by the methods described herein facilitates its production in large quantities. Another advantage attributable to the extrusion process is that it enables flexibility in designing cross-section of the flow channels, which may be designed to achieve a large surface area to improve heat exchange. In addition, multiple sub-cross-sections (as described herein) may be easily provided within a single cooling element. Further, different types of extruded flow channels (e.g., profiles with micro-channels) may be provided with a U-flow of a coolant within the cooling element.

Similar advantages also apply to the flow reverse element, which is preferably manufactured by impact extrusion, die casting or plastic injection.

Preferably, the flow reverse element can be connected to the cooling element for sealing the flow channels to an exterior, preferably wherein the flow reverse element is connected to the cooling element via one or more of a brazing, lap, welding, butt joint, gluing and/or screwing.

Connected may be understood that the flow reverse element and the cooling element are rigidly attached. In an example, said connection may be released without destruction of the components. In case of a brazing and/or lap joint suitable areas for joining the components should be provided for. The connection serves the purpose to substantially provide a gasket to facilitate tightness. Preferably the coolant should not leak to the exterior.

In case the flow reverse element is connected to the cooling element via screwing it may be possible to provide for a sealing, such as an O-ring.

In a further preferred embodiment, the flow reverse element is a separate element adapted to be connected to the cooling element.

A further aspect of the invention is directed to a vehicle comprising a cooling system according to any of the preceding claims. Optionally, the cooling system is fixed to the vehicle.

It is noted that the same features and advantages as described above with respect to the cooling system are also applicable to the vehicle comprising such a cooling system.

### Brief description of the figures

In the following, the accompanying figures are briefly described:
Fig. 1 illustrates an exemplary cooling system according to one aspect of the invention;
Fig. 2 illustrates an exemplary cooling system according to an embodiment of the invention;
Fig. 3 illustrates an exploded view of an exemplary cooling system according to a similar embodiment as the one shown in Fig. 2;
Fig. 4 illustrates a flow reverse element according to the embodiment shown in Fig. 3 in more detail;
Fig. 5 illustrates two cooling systems according to any one of the embodiments described herein;
Fig. 6 illustrates a mounting function of the flow reverse element according to any one of the embodiments described herein in more detail;
Fig. 7 illustrates a flow reverse element according to another embodiment.

### Detailed description of the figures

In the subsequent passages, the invention is described with reference to the accompanying figures in more detail. It is noted that further embodiments are certainly possible, and the below explanations are provided by way of example only, without limitation.

While specific feature combinations are described in the following with respect to the exemplary embodiments of the present invention, it is to be understood that not all features of the discussed embodiments have to be present for realizing the invention, which is defined by the subject matter of the claims. The disclosed embodiments may be modified by combining certain features of one embodiment with one or more features of another embodiment. Specifically, the skilled person will understand that features, components and/or functional elements of one embodiment can be combined with technically compatible features, components and/or functional elements of any other embodiment of the present invention given that the resulting combination falls within the definition of the invention provided by the claims.

Throughout the present figures and specification, the same reference numerals refer to the same elements. The figures may not be to scale, and the relative size, proportions, and depiction of elements in the figures may be exaggerated for clarity, illustration, and convenience.

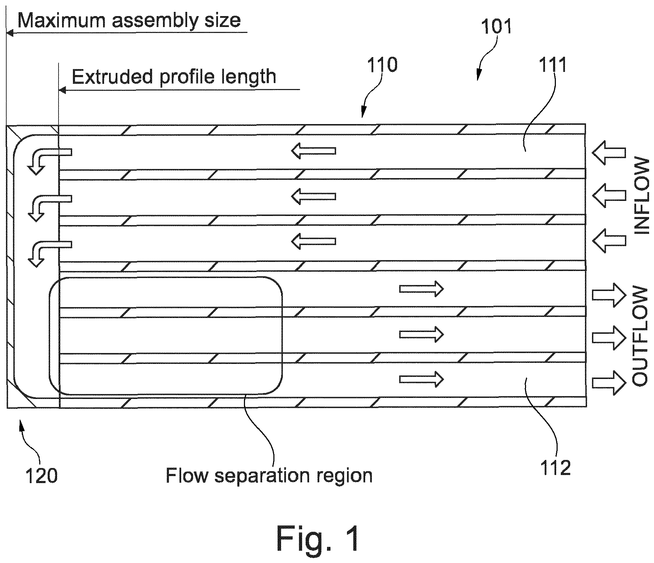

Fig. 1 illustrates an exemplary cooling system 101 according to one aspect of the invention. It shows a cooling element 110 and a closing cap 120. The cooling element 110 has three inflow channels, from which one inflow channel 111 is indicated. The cooling element 110 further has three outflow channels, from which one outflow channel 112 is indicated.

Fig. 1 further indicates an exemplary maximum assembly size, which sets a size limit for the closing cap 1201, and an exemplary extruded profile length of the cooling element 110.

In this example, when liquid coolant circulates inside such a cooling system 101, the cooling element 110, e.g., the profile, is sealed by the closing cap 120 to maintain leakproofness.

The depicted cooling system 101 may lead to flow disturbances and/or flow separation of the liquid coolant, which increases the pressure loss of the flow. This is indicated in this figure by the flow separation region in the lower left part of Fig. 1. Typically, such a separation occurs at tight turns of the liquid coolant. In such a region, heat exchange is severely limited, which adversely affects cooling efficiency and hence risks failure of electronic parts to be cooled by such a cooling system 101.

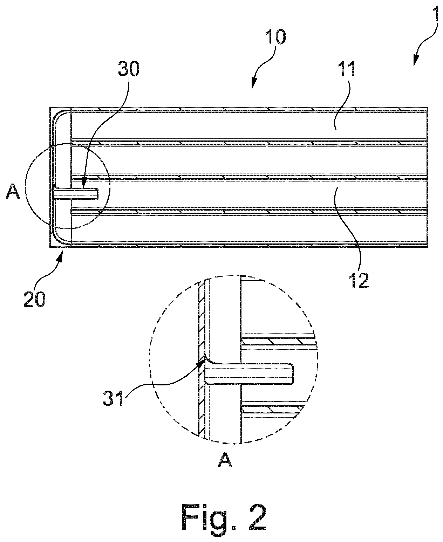

Fig. 2 illustrates an exemplary cooling system 1 according to an embodiment of the invention. It shows a cooling element 10 and a flow reverse element 20. The cooling element 10 has two flow channels, from which one flow channel 11 is indicated. Said one flow channel 11 could be the first flow channel 11. The cooling element 10 further has two outflow channels, from which one outflow channel 12 is indicated. Said one flow channel 12 could be the second flow channel 1. A plurality of channels is possible, and the embodiment is not limited to any specific number thereof.

The flow reverse element 20 has a geometrical expansion such that it complies with typical space requirements. These requirements may follow from the application of the cooling system 1 in an automotive sector to cool down electronic devices.

The cooling system 1 also comprises a flow guiding element 30. The flow guiding element 30 is configured to guide at least part of the coolant from the first flow channel 11 to the second flow channel 12.

Furthermore, the flow guiding element 30 may at least partially project in the second flow channel 12. The flow guiding element 30 may be integral with the flow reverse element 20, such that both elements are a single piece. The flow guiding element 30 projects from the flow reverse element 20 into the second flow channel 12. Although not shown in this figure, it is appreciated that a flow guiding element 30 projects into each flow channel into which flow is directed from the flow reverse element 20. This may further promote an improved flow. The flow guiding element 30 comprises a substantially rounded surface 31 (it may be better seen in the detail marked "A" in this figure) at a portion where the flow guiding element merges with the flow reverse element 20. The rounded surface 31 may at least partially face a direction of flow in the flow reverse element 20. In this figure, the direction may be at least partially from the top to the bottom.

The flow reverse element 20 may be connected to the cooling element 10 for sealing the flow channels 11 and 12 to an exterior.

This arrangement has the advantage that the fluid, such as a coolant, is properly guided from the first 11 to the second 12 flow channel. In particular, a pressure loss is mitigated compared to conventional cooling systems, as the flow can be guided without disturbances, development of vortices and/or flow separation. This promotes an increased cooling efficiency, as substantially no regions of flow separation occur.

Another advantage attributable to this arrangement is that the overall size of the flow reverse element 20 can be kept small, whilst achieving the afore-mentioned advantage. Thereby, the cooling element's 10 size is relatively large compared to the overall size of the cooling system 1, which facilitates to provide a large cooling surface for cooling parts.

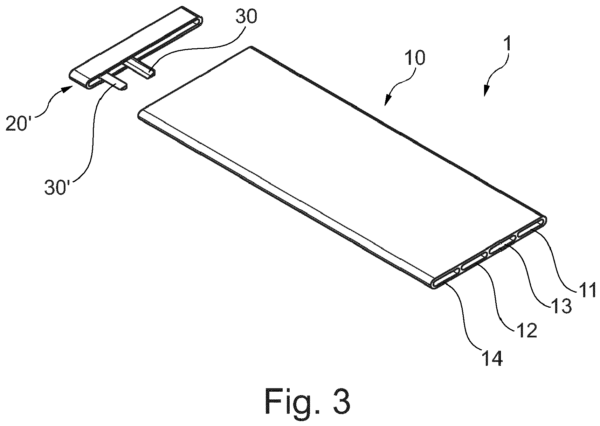

Fig. 3 illustrates an exploded view of an exemplary cooling system 1 according to a similar embodiment as the one shown in Fig. 2. Compared to Fig. 2, the cooling system 1 is shown in an exploded view to facilitate the understanding thereof. The cooling element 10 has two inflow channels 11, 13 and two outflow channels 12, 14. The reverse element 20' has two flow guiding elements 30, 30'. As the skilled person will appreciate, in assembled condition, flow guiding element 30 extends into outflow channel 12 and flow guiding element 30' extends into outflow channel 14.

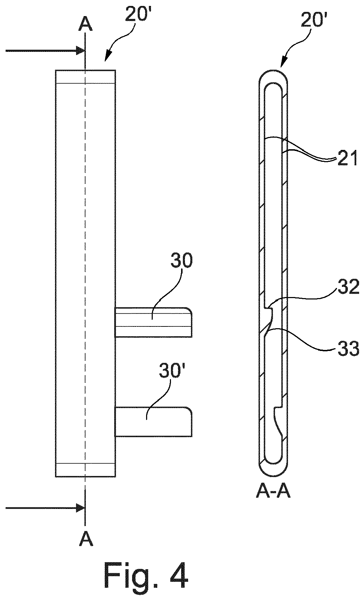

Fig. 4 shows the flow reverse element 20' according to the embodiment shown in Fig. 3 in more detail. The right part of Fig. 4 shows the flow reverse element 20' of its left part when cut in the "A-A" line and viewed from the left side. The flow reverse element 20' is shown in isolation, e.g., not in an assembled state with the cooling element. The two flow guiding elements 30, 30' are arranged in an alternating manner on the opposing inner sides 21 of the flow reverse element 20'.

It can be seen that the flow guiding elements 30, 30' are shaped as a blade, having a thicker portion 32 on a side facing a direction of flow of the coolant in the flow reverse element 20' and a thinner portion 33 on an opposite side.

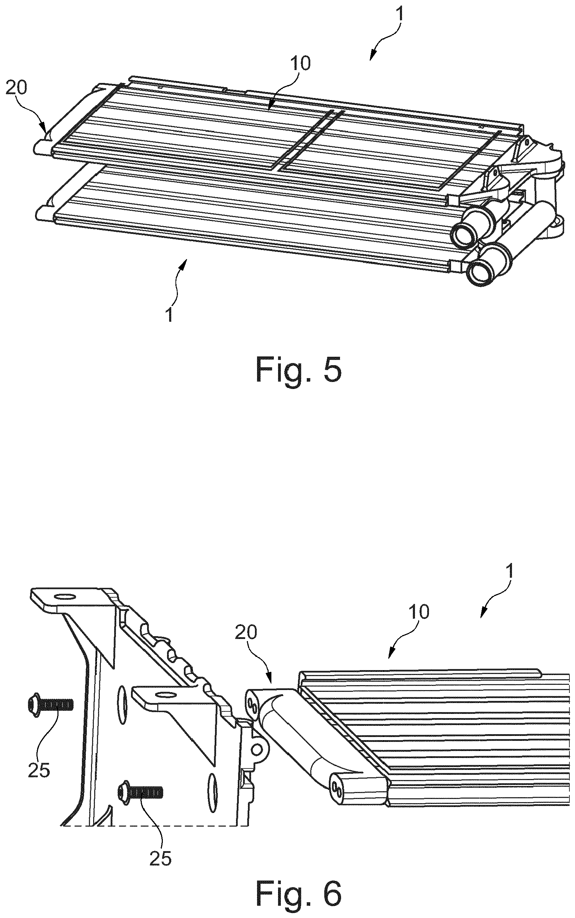

Fig. 5 illustrates two cooling systems 1 according to any one of the embodiments described herein. The cooling element 10 and the flow reverse element 20 of the cooling system 1 depicted in an upper part of the figure are indicated (the flow reverse element 20 may also be the flow reverse element 20' or 20" as described herein). For brevity, the components in the respective cooling system 1 depicted in a lower part of the figure are not indicated. The cooling systems 1 may be provided with a coolant, as shown on the right hand side of Fig. 5. Further, the coolant may flow out of the cooling systems 1 as shown on the right hand side of Fig. 5 as well.

Fig. 6 illustrates a mounting function of the flow reverse element 20 according to any one of the embodiments described herein in more detail (accordingly, the flow reverse element 20 may also be the flow reverse element 20' or 20" as described herein). The flow reverse element 20 comprises two fastening means 25 so as to act as a mounting bracket to external parts. The external parts maybe parts of a vehicle.

The upper part of the right hand side of this figure shows a combination of a circular and pentagonal cross-sections. Thus, it maybe understood that the cross-section of one flow channel may comprise one or more sub-cross-sections in one plane. The lower part of the right hand side of this figure shows a rectangular cross-section.

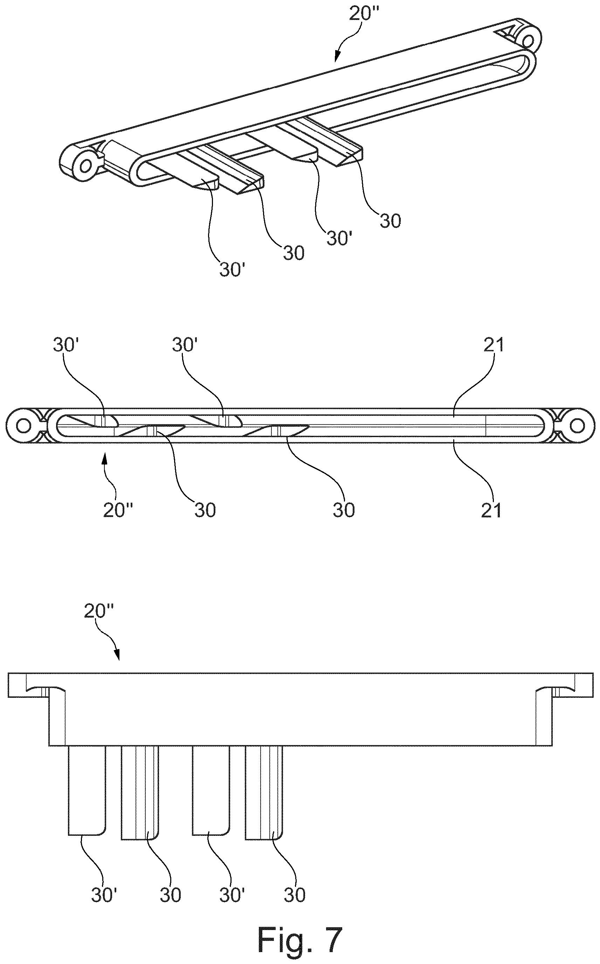

Fig. 7 illustrates a flow reverse element 20" according to another embodiment. The flow reverse element 20" is shown in a perspective view (top) a side view from the right (middle) and a top view (bottom). The flow reverse element 20" comprises two pairs of flow guiding elements 30, 30'. The flow guiding elements 30, 30' are arranged in an alternating manner on opposing inner sides 21 of the flow reverse element 20".

The flow guiding elements 30, 30' are elongated in the direction of flow channels of a cooling element as described herein (not shown in this figure). This facilitates a projection into the cooling element to a large extent (e.g., about 60% of a length of the flow guiding elements 30).

It will be apparent to those skilled in the art that numerous modifications and variations of the described examples and embodiments are possible in light of the above teaching. The disclosed examples and embodiments are presented for purposes of illustration only. Other alternate embodiments may include some or all of the features disclosed herein. Therefore, it is the intent to cover all such modifications and alternate embodiments as may come within the true scope of this invention.

### List of reference signs

- 101: cooling system (of one aspect of the invention)
- 110: cooling element (of one aspect of the invention)
- 111: inflow channel (of one aspect of the invention)
- 112: outflow channel (of one aspect of the invention)
- 120: closing cap (of one aspect of the invention)

- 1: cooling system
- 10: cooling element
- 11, 13: (in)flow channel
- 12, 14: (out)flow channel

- 20, 20', 20": flow reverse element
- 30, 30': flow guiding element
- 31: substantially rounded surface
- 32: thicker portion
- 33: thinner portion

## Claims

1. A cooling system (1) for an electrical control unit of a vehicle, the cooling system (1) comprising:
a cooling element (10) comprising a first (11) and second (12) flow channel for a coolant;
a flow reverse element (20; 20'; 20") adapted to guide coolant from the first flow channel (11) to the second flow channel (12);
a flow guiding element (30; 30') for guiding at least part of the coolant from the first flow channel (11) to the second flow channel (12).

2. The cooling system (1) according to the preceding claim, wherein the flow guiding element (30; 30') at least partially projects in the second flow channel (12);
optionally wherein the flow guiding element (30; 30') projects from the flow reverse element (20; 20'; 20") into the second flow channel (12).

3. The cooling system (1) according to any one of the preceding claims, wherein the flow guiding element (30; 30') is part of the flow reverse element (20; 20'; 20"), preferably integral with the flow reverse element (20; 20'; 20").

4. The cooling system (1) according to any one of the preceding claims, wherein the flow guiding element (30; 30') comprises a substantially rounded surface (31) at a portion where the flow guiding element (30; 30') merges with the flow reverse element (20; 20'; 20").

5. The cooling system (1) according to any one of the preceding claims, wherein the flow guiding element (30; 30') is shaped as a blade, having a thicker portion (32) on a side facing a direction of flow of the coolant in the flow reverse element (20; 20'; 20") and a thinner portion (33) on an opposite side.

6. The cooling system (1) according to any one of the preceding claims, wherein the flow reverse element (20; 20'; 20") has two opposing inner sides (21) defining a flow path in between, wherein the flow guiding element (30; 30') extends into said flow path
to at least 10%, preferably at least 20%, more preferably at least 30%, even more preferably at least 40%, most preferably at least 50% of a width of the flow path; and/or
to at most 90%, preferably at most 80%, more preferably at most 70%, even more preferably at most 60%, most preferably at most 50% of a width of the flow path.

7. The cooling system (1) according to any one of the preceding claims, wherein the flow reverse element (20; 20'; 20") has an elongate shape, wherein the largest dimension is substantially perpendicular to the direction of the flow channels and the width dimension is in the direction of the coolant in the flow channels,
wherein the largest dimension is at least 2 times larger than the width, preferably at least 4 times larger, more preferably at least 6 times larger, even more preferably at least 8 times larger and further more preferably at least 10 times larger.

8. The cooling system (1) according to any one of the preceding claims, wherein one or more of the flow channels (11, 12, 13, 14) has/have a cross-section of at most 10 cm², preferably at most 5 cm², more preferably at most 2 cm², even more preferably at most 1 cm².

9. The cooling system (1) according to any one of the preceding claims, wherein the flow guiding element (30; 30') projects into the second flow channel (12) by at least 10%, preferably at least 20%, more preferably at least 30%, even more preferably at least 40%, further more preferably at least 50%, most preferably at least 60% of a length of the flow guiding element (30; 30').

10. The cooling system (1) according to the preceding claim when referred back to claim 6, wherein at least two flow guiding elements (30; 30') are arranged in an alternating manner on the opposing inner sides of the flow reverse element (20; 20'; 20").

11. The cooling system (1) according to any one of the preceding claims, wherein the cooling element (10) is a substantially flat plate adapted for being connected to parts to be cooled;
optionally wherein the flow reverse element (20; 20'; 20") comprises one or more, preferably two fastening means (25) so as to act as a mounting bracket to external parts.

12. The cooling system (1) according to any one of the preceding claims, wherein the cooling element (10) is made of aluminum, preferably manufactured by extrusion, more preferably by direct extrusion;
optionally wherein the flow reverse element (20; 20'; 20") is made of aluminum, preferably manufactured by impact extrusion, die casting or plastic injection.

13. The cooling system (1) according to any one of the preceding claims, wherein the flow reverse element (20; 20'; 20") can be connected to the cooling element (10) for sealing the flow channels (11, 12, 13, 14) to an exterior, preferably wherein the flow reverse element (20; 20'; 20") is connected to the cooling element (10) via one or more of a brazing, lap, welding, butt joint, gluing and/or screwing.

14. The cooling system (1) according to any one of the preceding claims, wherein the flow reverse element (20; 20'; 20") is a separate element adapted to be connected to the cooling element (10).

15. A vehicle comprising a cooling system (1) according to any of the preceding claims.
